# FASCICULE DE BREVET EUROPEEN

(11) **EP 1 533 582 B1**
(45) Date de publication et mention de la délivrance du brevet: **20.05.2015**
(21) Numéro de dépôt: 04292739.2
(22) Date de dépôt: 19.11.2004
(51) Int. Cl.: F25D 19/00, H01L 31/024

(54) **Doigt froid et dispositif d'observation comportant un tel doigt**
Kaltkopf und Observationsvorrichtung mit solchem Gerat
Cold finger and observation apparatus including such device

(30) Priorité: 20.11.2003 FR 0313585
(43) Date de publication de la demande: 25.05.2005
(73) Titulaire: Sagem Défense Sécurité, 92100 Boulogne-Billancourt (FR)
(72) Inventeur: Ruocco-Angari, Bernard, 75003 Paris (FR)
(74) Mandataire: Regimbeau

(56) Documents cités:
- EP-A- 0 494 001
- EP-A- 0 823 601
- US-A- 4 597 175
- US-A- 4 918 312
- US-A- 5 041 727
- US-A- 5 382 797

## Description

### DOMAINE GENERAL DE L'INVENTION

L'invention concerne un doigt froid formant support de refroidissement d'un détecteur infrarouge ainsi qu'un dispositif d'observation comportant un tel doigt.

### ETAT DE L'ART

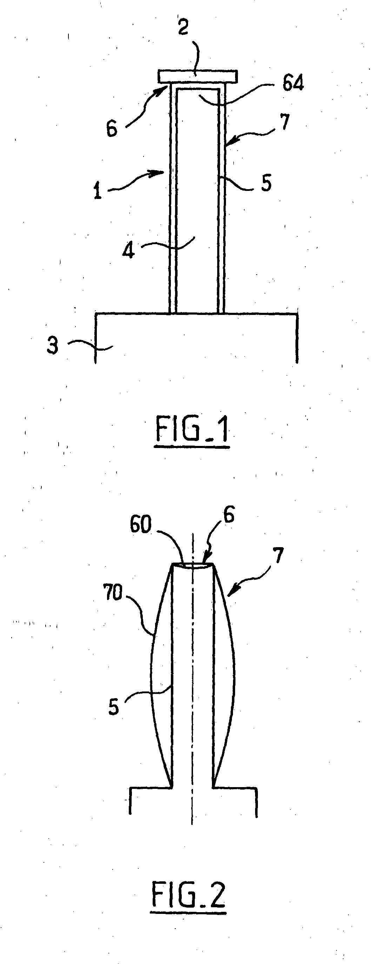

La figure 1 représente schématiquement un dispositif connu d'observation dans le domaine infrarouge.

Un tel dispositif comporte principalement une pièce 1 creuse et de forme allongée, préférentiellement cylindrique de révolution, appelée « doigt froid » par l'homme du métier, formant interface entre d'une part un détecteur infrarouge 2 en matériau actif et d'autre part un cryogénérateur 3 permettant d'amener le détecteur 2 à sa température de fonctionnement et d'assurer son maintien à cette température.

A cet effet, un fluide de refroidissement en provenance du cryogénérateur 3 circule à l'intérieur 4 du doigt 1 et refroidit continûment le détecteur 2. On référence par 5 les parois du doigt 1, par 6 l'extrémité supportant le détecteur 2 et opposée au cryogénérateur 3 et enfin par 7 les côtés du doigt 1.

Le cryogénérateur 3 peut être de plusieurs types.

Il peut s'agir d'une machine à détente d'un gaz sous haute pression à l'extrémité intérieure 64 du doigt 1, la détente refroidissant ainsi le détecteur 2.

Il peut également s'agir d'une machine cyclique utilisant par exemple le principe du cycle de Stirling. Dans ce cas, l'intérieur 4 du doigt 1 comporte un échangeur thermique.

Dans les deux cas, le doigt froid 1 est une source de microphonie de par le couplage qu'il crée entre le détecteur 2 et le cryogénérateur 3. Dans la suite de la présente description, on appelle « microphonie » tous les phénomènes de réponse du détecteur 2 à autre chose que le flux de photons dans le domaine infrarouge qui perturbent la mesure du détecteur.

D'une part, les parois du doigt 1 doivent être aussi fines que possible. Pour exemple, pour un doigt ayant une hauteur de 50 mm et un diamètre extérieur de 6 à 10 mm, les parois 5 ont une épaisseur de l'ordre de 0.1 mm. Il y a deux principales raisons à cette finesse des parois.

Premièrement, des parois 5 fines évitent une dépense d'énergie frigorifique trop importante de la part du cryogénérateur 3, car elles sont amenées à la température de fonctionnement du détecteur plus rapidement.

Deuxièmement, des parois 5 fines évitent les fuites thermiques dans les parois 5, l'énergie frigorifique étant alors transmise à d'autres éléments que le détecteur 2 du dispositif. La température de fonctionnement est donc maintenue plus facilement, avec une dépense d'énergie frigorifique superflue aussi faible que possible.

D'autre part cependant, la figure 2 montre que les parois 5 fines ne permettent pas d'éviter une déformation du doigt 1 lors de son fonctionnement, la déformation prenant sensiblement la forme d'une « barrique » par une courbure 60 de l'extrémité 6 et une courbure 70 des cotes 7.

Sur l'ensemble des figures, on a supposé que l'extrémité 6 devenait concave lors de la déformation, mais l'extrémité 6 peut également devenir convexe dans certains doigts 1.

Dans le cas d'un cryogénérateur 3 à détente, la déformation est quasi statique et relativement importante du fait de la haute pression régnant à l'intérieur 4 du doigt froid. La pression susceptible de déformer le doigt froid monte brutalement à une pression de l'ordre de 10 bars quand on ouvre la bouteille contenant le gaz sous pression (de l'ordre de 700 bars) en amont de la détente. La déformation du doigt est lentement décroissante dans le temps en fonction de la détente du fluide et de l'épuisement du réservoir de fluide à détendre.

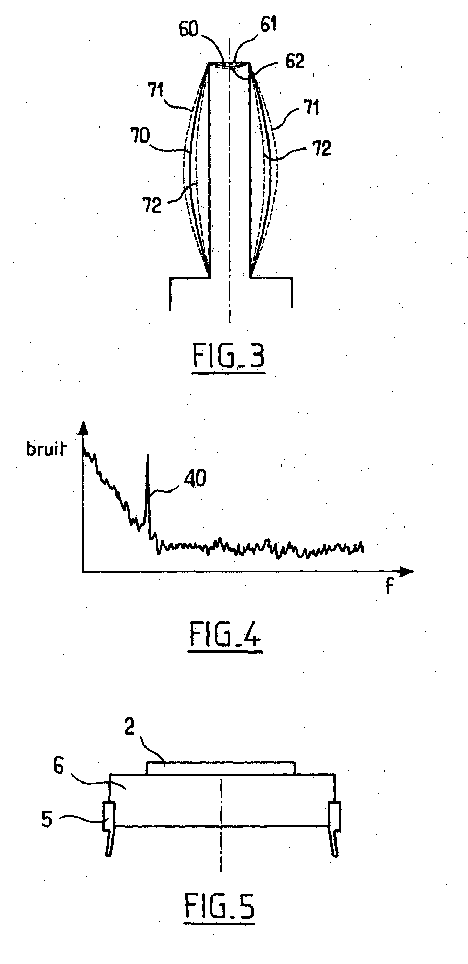

La figure 3 montre que dans le cas d'un cryogénérateur 3 cyclique, la déformation due à la pression régnant à l'intérieur 4 du doigt froid 1 est du même ordre de grandeur que la déformation dans le cas d'un cryogénérateur à détente - la pression intérieure est en effet de l'ordre de 20 à 50 bars - mais varie cycliquement en fonction des cycles de la machine autour d'une position moyenne. Les profils en pointillés 61 et 62 ainsi que 71 et 72 montre les oscillations des parois du doigt 1 autour des positions moyennes 60 et 70.

Dans les deux cas, la courbure 60 au niveau de l'extrémité 6 engendre des microcontraintes au niveau du détecteur 2 fixé sur l'extrémité 6.

Du fait que le détecteur 2 est en matériau actif - généralement piézo électrique ou piézo résistif -, les microcontraintes engendrent à leur tour une variation de résistance dans le détecteur 2, et faussent ainsi le signal de mesure et causent du bruit.

Le bruit engendré par ces contraintes dans le détecteur 2 est considérable même pour des déformations du doigt 1 très faibles.

La figure 4 montre que dans le cas d'un cryogénérateur 3 cyclique, il y a apparition d'un pic de bruit 40 dans le signal de mesure, le bruit cyclique étant dû à la contrainte cyclique au niveau du détecteur 2. La fréquence du bruit 40 correspond à la fréquence du cycle du cryogénérateur 3 et est de l'ordre de 50 Hz.

Ce bruit 40 est très gênant, car sa fréquence correspond sensiblement à la fréquence d'utilisation du détecteur 2 dans le domaine de l'imagerie (typiquement de l'ordre de 25 à 60 Hz).

Dans les deux cas de cryogénérateur 3, il faut éliminer le bruit au niveau du détecteur.

Plusieurs dispositifs de l'art antérieur essaient de résoudre ce problème.

Une première solution connue pour éliminer le bruit au niveau du détecteur 2 est représentée schématiquement à la figure 5.

Selon cette solution, on renforce en épaisseur l'extrémité 6 du doigt et/ou le détecteur 2 afin que l'extrémité 6 et/ou le détecteur 2 soient moins flexibles.

On peut également ajouter un substrat entre l'extrémité 6 et le détecteur 2 pour éviter la déformation du détecteur 2.

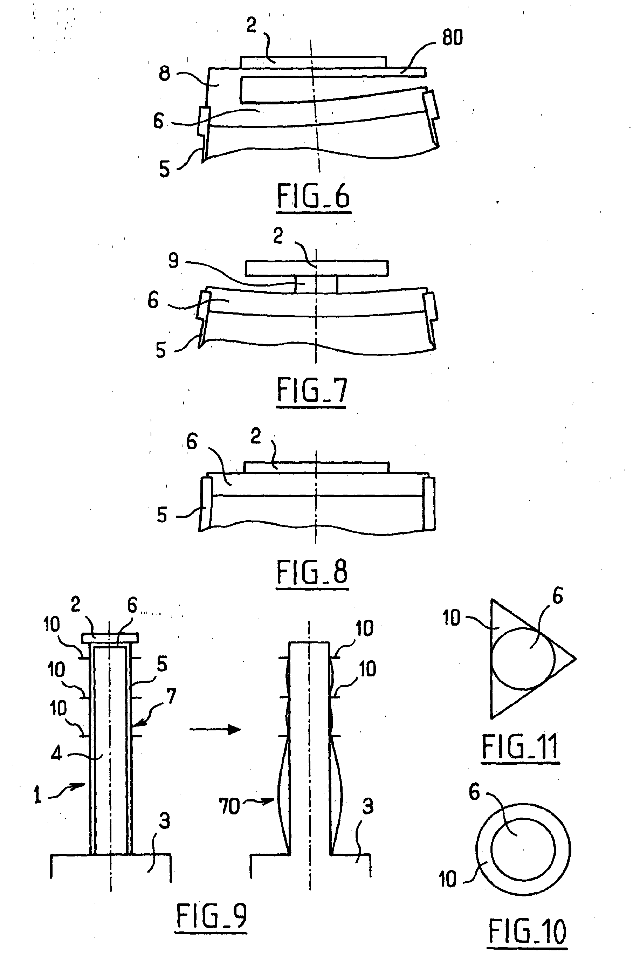

Une deuxième solution connue pour éliminer le bruit au niveau du détecteur 2 est représentée schématiquement aux figures 6 et 7.

Selon cette solution, on isole mécaniquement l'extrémité 6 du doigt et le détecteur 2 afin que les contraintes ne soient pas transmises de l'extrémité 6 au détecteur 2.

On peut ainsi ajouter une charnière 8 comme le montre la figure 6, ou une rotule 9 comme le montre la figure 7.

Ainsi, sur la figure 6, l'extrémité 6 comporte un coude 8 formant charnière venue de matière sur l'extrémité 6. Un support plan 80 du détecteur 2 venu de matière sur la charnière 8 s'étend sensiblement parallèlement à l'extrémité 6.

La figure 6 montre que le support 80 reste plan lors de la déformation du doigt 1. Le détecteur 2 n'est donc plus soumis aux contraintes.

Sur la figure 7, l'extrémité 6 comporte une rotule 9 formant support plan du détecteur 2.

La figure 7 montre que la rotule 9 absorbe la déformation du doigt 1. Le détecteur 2 n'est encore une fois plus soumis aux contraintes.

Une troisième solution connue pour éliminer le bruit au niveau du détecteur 2 est représentée schématiquement à la figure 8.

Selon cette solution, on renforce en épaisseur les parois 5 des côtés 7 du doigt 1. Les parois 5 sont moins flexibles et le doigt 1 ne se déforme pas. On évite ainsi la courbure du détecteur 2.

Les solutions de l'art antérieur présentent cependant des inconvénients.

La première solution présente l'inconvénient principal qu'il faut dépenser davantage d'énergie frigorifique ou de temps pour amener le détecteur à sa température de fonctionnement, du fait du renfort en épaisseur de l'extrémité 6 et/ou du détecteur 2 ou de la présence d'un substrat. La masse thermique du système augmente fortement.

La deuxième solution présente également l'inconvénient d'une masse thermique fortement accrue, du fait de la présence de la charnière 8 ou de la rotule 9. De plus, la charnière 8 ou la rotule 9 engendrent une variation de la hauteur du doigt 1 et de sa position par rapport au plan focal, ce qui fausse les mesures du fait que le détecteur 2 n'est pas toujours à la même position. Enfin, la complexité et donc le coût de réalisation du doigt 1 augmentent.

La troisième solution présente également l'inconvénient d'une masse thermique fortement accrue, et les pertes thermiques dans les parois 5 vers d'autres parties du dispositif d'observation sont importantes. Le cryogénérateur doit donc dépenser plus d'énergie pour amener et maintenir le détecteur 2 à sa température de fonctionnement.

Le document EP 0 494 001 divulgue un doigt de refroidissement comportant sur sa paroi latérale des zones de renforcement venues radialement de matière sur ladite paroi. Les zones de renforcement s'étendent longitudinalement par rapport au doigt, et ce sur la plus grande partie du doigt. La paroi latérale du doigt ne s'épaissit que dans les zones de renfoncement. Les zones de renforcement agissent comme des raidisseurs à la manière de contreforts longitudinaux dans un ouvrage d'architecture.

De telles zones de renforcement longitudinal n'apportent cependant pas satisfaction.

La fabrication d'un doigt comportant de telles zones de renforcement est délicate et complexe.

Du fait de l'extension longitudinale des zones de renforcement, le doigt est préférentiellement en une seule pièce, car il est difficile de rapporter longitudinalement les zones de renforcement sur la paroi latérale du doigt. Il est également difficile d'usiner les zones de renforcement d'un tel doigt dans le cas où le doigt est monobloc, puisqu'il y a alors deux axes d'usinage.

La complexité de fabrication du doigt avec des renforcements longitudinaux fait que la circularité du doigt est difficile à obtenir.

La fabrication présente donc un fort taux de rebut.

US-5 382 797 divulgue un doigt froid pour un détecteur infrarouge refroidi par un cryostat.

### PRESENTATION DE L'INVENTION

L'invention a pour but de résoudre les inconvénients précédents.

Un des buts de l'invention est de proposer un doigt froid dont la déformation lors du fonctionnement est la plus faible possible, tout en proposant un doigt dont la masse thermique est très faiblement accrue.

Un des autres buts de l'invention est de proposer un doigt froid dans lequel les pertes thermiques sont réduites au minimum.

Ainsi, un des buts de l'invention est de proposer un doigt froid renforcé, mais dont la section moyenne n'est pas augmentée significativement.

Ainsi, un des autres buts de l'invention est de proposer un doigt froid renforcé dont la circularité est améliorée par rapport à l'art antérieur.

Ainsi, un des autres buts de l'invention est de proposer un doigt froid facile à usiner.

Un des autres buts de l'invention est de proposer un doigt froid renforcé qui puisse être fabriqué en plusieurs pièces.

Un but corrélé est de proposer une rigidité supérieure de ce doigt froid autorisant ainsi une réalisation avec un plus faible taux de rebut.

A cet effet, l'invention propose un doigt froid selon la revendication 1.

Des modes de réalisation avantageux sont présentés dans les revendications dépendantes concernant un doigt froid.

L'invention concerne également un dispositif d'observation infrarouge comportant un doigt selon l'invention.

### PRESENTATION DES FIGURES

D'autres buts et avantages de l'invention ressortiront de la description qui suit, qui est purement illustrative et non limitative, et qui doit être lue en regard des dessins annexés sur lesquels :
- la figure 1 représente schématiquement un doigt froid connu formant interface entre un cryogénérateur et un détecteur;
- la figure 2 représente schématiquement la déformation statique d'un doigt froid de l'état de l'art en fonctionnement;
- la figure 3 représente schématiquement la déformation dynamique d'un doigt froid selon l'état de la technique en fonctionnement;
- la figure 4 représente schématiquement le bruit engendré par la déformation dynamique du doigt froid selon la figure 3;
- la figure 5 représente schématiquement une première solution connue d'élimination du bruit au niveau du détecteur;
- les figures 6 et 7 représentent schématiquement une deuxième solution connue d'élimination du bruit au niveau du détecteur;
- la figure 8 représente schématiquement une troisième solution connue d'élimination du bruit au niveau du détecteur;
- la figure 9 représente schématiquement en coupe longitudinale un mode de réalisation possible d'un doigt froid selon l'invention; et
- les figures 10 et 11 représentent schématiquement une coupe radiale d'un mode de réalisation possible d'un doigt froid selon l'invention.
   Dans l'ensemble des figures, les éléments similaires portent des références numériques identiques.

### DESCRIPTION DETAILLEE

La figure 9 représente schématiquement un doigt froid 1 d'un dispositif d'observation infrarouge comportant principalement une pièce creuse de forme allongée. Préférentiellement, le doigt 1 est de forme cylindrique et de révolution.

Le doigt froid 1 forme une interface entre d'une part un détecteur 2 infrarouge fixé à une des ses extrémités 6, et d'autre part un cryogénérateur 3 disposé à l'autre de ses extrémités.

Le détecteur 2 est un détecteur infrarouge en matériau actif, par exemple du type matériau piézo-électrique ou piézo-résistif.

Le cryogénérateur 3 peut être classiquement du type machine à détente connue ou du type machine cyclique connue.

Le doigt froid 1 permet au cryogénérateur 3 de refroidir et de maintenir le détecteur 2 à une température de fonctionnent. Un fluide de refroidissement du détecteur 2 circule ou est détendu à l'intérieur 4 du doigt 1.

Le doigt froid 1 comporte des parois fines 5 formant les côtés 7 du doigt 1. Ainsi, les parois 5 d'un doigt 1 ayant une hauteur de 50 mm et ayant un diamètre extérieur de l'ordre de 6 à 10 mm ont une épaisseur de l'ordre de 0.1 mm.

De façon générale, le doigt 1 est en métal, par exemple en acier inoxydable ou en alliage de titane.

Selon l'invention, le doigt froid 1 comporte sur sa surface latérale extérieure au moins une ailette 10 de renfort.

Chaque ailette 10 s'étend sensiblement radialement par rapport à la surface latérale du doigt 1. Une extension non radiale est bien entendu possible. Chaque ailette peut ainsi se diriger, lors de son extension à partir de la pièce allongée du doigt froid, vers le détecteur 2 ou vers le cryogénérateur 3. La base de chaque ailette forme cependant un cerclage au niveau de la pièce allongée du doigt.

En effet, l'extension longitudinale de chaque ailette par rapport à la longueur du doigt est limitée. Le ratio de l'extension longitudinale de chaque ailette au niveau du doigt froid par rapport à la hauteur du doigt froid est compris par exemple entre les valeurs 1/20 et 1/200, préférentiellement compris entre 1/30 et 1/100, et très préférentiellement de l'ordre de 1/50. L'extension longitudinale de chaque ailette au niveau de la jonction entre ladite ailette et la pièce allongée du doigt est juste suffisante pour donner de la rigidité à l'ailette, tout en étant facile à usiner. L'ailette forme donc un anneau autour de la pièce allongée du doigt froid.

Le but de chaque ailette 10 est de rigidifier localement la paroi 5 du doigt 1 afin d'éviter sa déformation, et notamment de son extrémité 6. Si l'extrémité 6 n'est pas déformée, on n'entraîne pas une déformation du détecteur 2. La paroi 5 est donc plus épaisse localement.

Cependant, le fait que les ailettes 10 augmentent l'épaisseur des parois 5 du doigt 1 localement - et non pas sur toute la hauteur du doigt comme pour la solution de la figure 8 - permet de ne pas augmenter significativement la section moyenne des parois 5. Ainsi, on n'augmente pas de façon importante la masse thermique du doigt 1. Les pertes thermiques dans les parois 5 sont donc réduites au minimum.

Chaque ailette 10 joue vis-à-vis de la déformation du doigt 1 le même rôle que d'un cerclage d'un tonneau qui empêche les douves de s'écarter sous l'effet de la pression du liquide.

Le fait que les ailettes n'augmentent pas longitudinalement l'épaisseur comme dans le document EP 0 494 001 simplifie la fabrication du doigt. Le fait que l'extension ne s'effectue que selon un cerclage ou en anneau autour de la pièce allongée permet que la pièce puisse être facilement usinée, puisqu'on peut usiner la pièce selon un axe unique de révolution, ou fabriquée en plusieurs pièces, les ailettes étant alors rapportées sur la pièce allongée du doigt. Le taux de rebut est donc moindre que dans l'art antérieur.

La masse thermique du doigt 1 augmente certes, mais de façon très faible, en fonction de la géométrie, du nombre et de la position des ailettes sur le doigt.

Les pertes par rayonnement sur la surface des ailettes 10 sont faibles
- elles ne représentent d'une manière générale que 20% des pertes totales
- et les pertes par conduction dans les parois 5 sont également faibles dans la mesure où la section longitudinale et la section radiale de chaque ailette 10 restent faibles.

Chaque ailette 10 peut être venue de matière sur la surface latérale.

Dans ce cas, la complexité de fabrication du doigt augmente. Cependant, les ailettes 10, du fait du gain de rigidité qu'elles apportent, permettent d'améliorer la circularité du doigt 1 d'obtenir une meilleure qualité globale du doigt. On peut donc réaliser le doigt froid avec un plus faible taux de rebut.

Chaque ailette 10 peut être rapportée sur la surface latérale extérieure de la pièce allongée formant la partie principale du doigt et enfilée autour du doigt, telle un anneau.

Dans ce cas, on peut choisir pour l'ailette 10 un matériau ayant un coefficient de dilatation thermique différent de la pièce allongée du doigt 1.

Ainsi, le coefficient de dilatation thermique de chaque ailette 10 peut être inférieur à celui de la pièce allongée du doigt 1. Chaque ailette 10 serre davantage la pièce allongée du doigt 1 au fur et à mesure de la montée en température du détecteur 2 et du doigt lors du fonctionnement du dispositif d'observation.

Dans tout les cas, les formes de la section longitudinale et de la section radiale de chaque ailette, ainsi que leurs dimensions sont choisies pour minimiser la déformation du doigt et les pertes thermiques dans les ailettes.

Ainsi, les sections longitudinales des ailettes peuvent être rectangulaires comme le montre la figure 9, ou triangulaires par exemple ou de forme quelconque.

De mêmes, l'extension radiale de chaque ailette 10 par rapport au doigt 1 peut être quelconque. On pourra par exemple avoir une extension radiale égale à l'épaisseur des parois du doigt 1.

La section longitudinale de chaque ailette 10 peut être en forme d'anneau circulaire comme le montre la figue 10, ou en forme de triangle dans lequel serait inscrit le doigt 1 comme le montre la figure 11. D'autres sections longitudinales des ailettes sont bien entendu possibles.

Dans le cas de la figure 11, on limite la surface des ailettes 10 - les pertes par rayonnement sont donc minimisées - en obtenant quand même la fonction de renfort et en minimisant la déformation.

Le nombre et la répartition des ailettes 10 les unes par rapport aux autres d'une part et par rapport au doigt d'autre part sont choisis également pour minimiser la déformation du doigt et les pertes thermiques dans les ailettes 10.

Ainsi, on peut, par exemple et selon les applications, disposer une seule ailette de renfort au milieu du doigt, ou plusieurs ailettes 10 uniformément réparties sur toute la hauteur du doigt, ou encore réparties de façon plus dense vers le haut du doigt que vers le bas du doigt.

La répartition des ailettes 10 prend notamment en compte le fait que le gradient de température est plus faible dans la partie basse du doigt proche du cryogénérateur que dans la partie haute ou le détecteur est en permanence chauffé par le flux de photons de l'observation.

## Revendications

1. Doigt (1) froid pour un dispositif d'observation infrarouge comportant une pièce creuse (4) de forme allongée et apte à former une interface entre d'une part un détecteur infrarouge (2) à une de ses extrémités (6) et d'autre part un cryogénérateur (3) à l'autre de ses extrémités, comportant sur sa surface latérale extérieure au moins une ailette (10) de renfort, **caractérisé en ce que** chaque ailette (10) forme un cerclage empêchant la déformation du doigt.

2. Doigt selon la revendication 1, **caractérisé en ce que** chaque ailette (10) est venue de matière sur la surface latéral et augmente localement l'épaisseur du doigt sans augmenter significativement sa section moyenne.

3. Doigt selon la revendication 1, **caractérisé en ce que** chaque ailette (10) est rapportée sur la surface latérale extérieure.

4. Doigt selon la revendication 3, **caractérisé en ce que** chaque ailette (10) et la pièce allongée sont dans un matériau ayant des coefficients de dilatation thermique différents.

5. Doigt selon la revendication 4, **caractérisé en ce que** le coefficient de dilatation thermique de chaque ailette (10) est inférieur à celui de la pièce allongée.

6. Doigt selon l'une des revendications 1 à 5, **caractérisé en ce que** les formes de la section longitudinale et de la section radiale de chaque ailette (10) ainsi que leurs dimensions sont choisies pour minimiser la déformation du doigt et les pertes thermiques dans les ailettes.

7. Doigt selon l'une des revendications 1 à 6, **caractérisé en ce que** le nombre et la répartition des ailettes les unes par rapport aux autres et par rapport au doigt sont choisis pour minimiser la déformation du doigt et les pertes thermiques dans les ailettes.

8. Doigt selon l'une des revendications 1 à 7, **caractérisé en ce que** chaque ailette (10) a une forme d'anneau.

9. Doigt selon l'une des revendications 1 à 7, **caractérisé en ce que** chaque ailette (10) a une forme sensiblement triangulaire dans lequel vient s'insérer la pièce allongée.

10. Dispositif d'observation infrarouge, **caractérisé en ce qu'**il comporte un doigt selon l'une des revendications précédentes.

## Patentansprüche

1. Kühlfinger (1) für eine Infrarot-Observationsvorrichtung, der ein längliches Hohlteil (4) umfasst, das imstande ist, eine Schnittstelle zwischen einerseits einem Infrarot-Detektor (2) an einem seiner Enden (6) und andererseits einem Kryogenerator (3) am anderen seiner Enden zu bilden, der auf seiner äußeren Seitenfläche mindestens einen Verstärkungsflügel (10) aufweist, **dadurch gekennzeichnet, dass** jeder Flügel (10) eine Umreifung bildet, die die Verformung des Fingers verhindert.

2. Finger nach Anspruch 1, **dadurch gekennzeichnet, dass** jeder Flügel (10) auf der Seitenfläche materialeinheitlich ist und lokal die Dicke des Kopfs vergrößert, ohne seinen mittleren Durchmesser signifikant zu erhöhen.

3. Finger nach Anspruch 1, **dadurch gekennzeichnet, dass** jeder Flügel (10) auf der äußeren Seitenfläche angebracht ist.

4. Finger nach Anspruch 3, **dadurch gekennzeichnet, dass** jeder Flügel (10) und das längliche Teil aus einem Material sind, das unterschiedliche Wärmeausdehnungskoeffizienten hat.

5. Finger nach Anspruch 4, **dadurch gekennzeichnet, dass** der Wärmeausdehnungskoeffizient jedes Flügels (10) kleiner als der des länglichen Teils ist.

6. Finger nach einem der Ansprüche 1 bis 5, **dadurch gekennzeichnet, dass** die Formen des Längsschnitts und des Radialschnitts jedes Flügels (10) sowie ihre Abmessungen gewählt sind, um die Verformung des Fingers und die Wärmeverluste in den Flügeln zu minimieren.

7. Finger nach einem der Ansprüche 1 bis 6, **dadurch gekennzeichnet, dass** die Anzahl und die Verteilung des Flügel zueinander und im Verhältnis zum Finger gewählt sind, um die Verformung des Fingers und die Wärmeverluste in den Flügeln zu minimieren.

8. Finger nach einem der Ansprüche 1 bis 7, **dadurch gekennzeichnet, dass** jeder Flügel (10) eine Ringform hat.

9. Finger nach einem der Ansprüche 1 bis 7, **dadurch gekennzeichnet, dass** jeder Flügel (10) eine etwa dreieckige Form hat, in die das längliche Teil eingesetzt ist.

10. Infrarot-Beobachtungsvorrichtung, **dadurch gekennzeichnet, dass** sie einen Finger nach einem der vorangehenden Ansprüche aufweist.

## Claims

1. A cold finger (1) for an infrared observation device including a hollow part (4) with an elongated shape and able to form an interface between an infrared detector (2) at one of its ends (6) on the one hand, and a cryogenerator (3) at the other one of its ends on the other hand, including on its outer lateral surface at least one reinforcing fin (10), **characterized in that** each fin (10) forms banding preventing deformation of the finger.

2. The finger according to claim 1, **characterized in that** each fin (10) is made integral with and on the lateral surface and locally increases the thickness of the finger without significantly increasing its average section.

3. The finger according to claim 1, **characterized in that** each fin (10) is added onto the outer lateral surface.

4. The finger according to claim 3, **characterized in that** each fin (10) and the elongated part are in a material having different thermal expansion coefficients.

5. The finger according to claim 4, **characterized in that** the thermal expansion coefficient of each fin (10) is less than that of the elongated part.

6. The finger according to one of claims 1 to 5, **characterized in that** the shapes of the longitudinal section and of the radial section of each fin (10) as well as their dimensions are selected for minimizing the deformation of the finger and thermal losses in the fins.

7. The finger according to one of claims 1 to 6, **characterized in that** the number and the distribution of the fins relatively to each other and relatively to the finger are selected for minimizing the deformation of the finger and thermal losses in the fins.

8. The finger according to one of claims 1 to 7, **characterized in that** each fin (10) is ring-shaped.

9. The finger according to one of claims 1 to 7, **characterized in that** each fin (10) has a substantially triangular shape into which the elongated part will be inserted.

10. An infrared observation device, **characterized in that** it includes a finger according to one of the preceding claims.
